(19) Europäisches Patentamt
European Patent Office
Office européen des brevets

(11) EP 3 496 133 A1

(12) DEMANDE DE BREVET EUROPEEN

(43) Date de publication:
12.06.2019 Bulletin 2019/24

(51) Int Cl.:
*H01L 21/20* $^{(2006.01)}$

(21) Numéro de dépôt: 18209588.5

(22) Date de dépôt: 30.11.2018

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: 08.12.2017  FR 1761827

(71) Demandeur: **Commissariat à l'Energie Atomique
et aux Energies
Alternatives
75015 Paris (FR)**

(72) Inventeurs:
• **FOURNEL, Frank
  38190 VILLARD-BONNOT (FR)**
• **LARREY, Vincent
  38140 LA MURETTE (FR)**
• **LOBO KEMP, SOFIA-ANTONIA
  38100 ECHIROLLES (FR)**
• **MAUGUEN, Gaëlle
  38000 GRENOBLE (FR)**

(74) Mandataire: **GIE Innovation Competence Group
310, avenue Berthelot
69372 Lyon Cedex 08 (FR)**

(54) **PROCEDE DE COLLAGE PAR ADHESION DIRECTE D'UN PREMIER SUBSTRAT A UN DEUXIEME SUBSTRAT**

(57)     Ce procédé de collage par adhésion directe d'un premier substrat (1) à un deuxième substrat (2), les premier et deuxième substrats (1, 2) comprenant respectivement des première et deuxième surfaces (10, 20) possédant une énergie d'adhésion initiale, comporte les étapes successives :
- prévoir les premier et deuxième substrats (1, 2) ;
- coller le premier substrat (1) au deuxième substrat (2) par une adhésion directe avec les première et deuxième surfaces (10, 20) ;
- décoller au moins partiellement les premier et deuxième substrats (1, 2) de manière à créer des charges électrostatiques sur des parties des première et deuxième surfaces (10, 20) ;
- coller de nouveau le premier substrat (1) au deuxième substrat (2) par une adhésion directe avec lesdites parties des première et deuxième surfaces (10, 20).

Fig. 5

## Description

### Domaine technique

L'invention se rapporte au domaine technique du collage par adhésion directe de deux substrats.
L'invention trouve notamment son application dans le transfert de couches minces pour la fabrication de dispositifs électroniques.

### Etat de la technique antérieure

Si l'on considère un procédé de collage par adhésion directe d'un premier substrat à un deuxième substrat, les premier et deuxième substrats comprenant respectivement des première et deuxième surfaces possédant une énergie d'adhésion initiale, il est connu de l'état de la technique, notamment du document F. Rieutord et al., « Dynamics of a Bonding Front », Phys. Rev. Lett., 94, 236101, 2005 (ci-après D1), qu'il existe un lien entre l'énergie adhésion initiale et la vitesse d'onde de collage des première et deuxième surfaces.
L'homme du métier recherche un procédé de collage par adhésion directe permettant d'obtenir une vitesse d'onde de collage la plus élevée possible, notamment pour limiter la présence de zones périphériques des première et deuxième surfaces qui peuvent ne pas être collées, ou encore pour compenser un voilage (« warp » en langue anglaise) des première et deuxième surfaces.

### Exposé de l'invention

A cet effet, l'invention a pour objet un procédé de collage par adhésion directe d'un premier substrat à un deuxième substrat, les premier et deuxième substrats comprenant respectivement des première et deuxième surfaces possédant une énergie d'adhésion initiale ;
le procédé étant remarquable en ce qu'il comporte au moins une étape consistant à créer des charges électrostatiques aux première et deuxième surfaces de manière à obtenir une énergie d'adhésion strictement supérieure à l'énergie d'adhésion initiale.
Ainsi, un tel procédé selon l'invention permet d'augmenter la vitesse d'onde de collage des première et deuxième surfaces, et ce grâce à ladite au moins une étape de création des charges électrostatiques qui permet d'augmenter l'énergie d'adhésion initiale des première et deuxième surfaces. En effet, comme évoqué dans D1, une augmentation de l'énergie d'adhésion des première et deuxièmes surfaces entraîne une augmentation de la vitesse d'onde de collage des première et deuxième surfaces, étant entendu que les conditions extérieures ne sont pas modifiées (e.g. nature du gaz, pression du gaz).

### Définitions

- Par « substrat », on entend un support physique autoporté, réalisé dans un matériau de base permettant la fabrication d'un dispositif électronique ou d'un composant électronique. Un substrat est classiquement une tranche (« wafer » en langue anglaise) découpée dans un lingot monocristallin de matériau semi-conducteur.
- Par « adhésion directe», on entend un collage spontané issu de la mise en contact direct de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre les deux surfaces. On parle également de collage par adhésion moléculaire ou de collage direct. Le collage par adhésion directe est avantageusement exécuté à température et pression ambiantes, et ne saurait être assimilé à un collage par thermocompression, à un collage eutectique ou encore à un collage anodique. Le collage par adhésion directe peut être suivi d'un recuit thermique de renforcement.
- Par « énergie d'adhésion », on entend l'énergie fournie par le contact entre les première et deuxième surfaces pour propager le collage direct. L'énergie d'adhésion se distingue de l'énergie d'adhérence qui est l'énergie nécessaire pour séparer les première et deuxième surfaces après leur collage.

Le procédé selon l'invention peut comporter une ou plusieurs des caractéristiques suivantes.
Selon une caractéristique de l'invention, ladite au moins une étape est exécutée de sorte que les charges électrostatiques créées sont réparties de manière aléatoire aux première et deuxième surfaces.
Ainsi, les inventeurs ont constaté qu'il n'existait pas de localisation à privilégier pour les charges électrostatiques. Il s'agit plutôt d'appliquer une densité surfacique de charges électrostatiques suffisante pour obtenir une énergie d'adhésion strictement supérieure à l'énergie d'adhésion initiale des première et deuxième surfaces.
Selon une caractéristique de l'invention, ladite au moins une étape est exécutée de sorte que l'énergie d'adhésion obtenue est comprise entre 50 mJ/m$^2$ et 150 mJ/m$^2$.
Ainsi, ladite au moins une étape est exécutée de sorte les densités surfaciques des charges électrostatiques créées permettent une telle énergie d'adhésion. Un avantage procuré est l'obtention d'une vitesse d'onde de collage élevée, c'est-à-dire comprise approximativement entre 10 mm/s et 40 mm/s.

Selon une caractéristique de l'invention, le procédé comporte les étapes successives :

a) prévoir les premier et deuxième substrats comprenant respectivement les première et deuxième surfaces possédant l'énergie d'adhésion initiale ;
b) appliquer des potentiels électriques aux première et deuxième surfaces de manière à créer des charges électrostatiques ;
c) coller le premier substrat au deuxième substrat par une adhésion directe avec les première et deuxième surfaces.

Ainsi, un avantage procuré par l'étape b), c'est-à-dire appliquer des potentiels électriques avant collage (i.e. des potentiels électriques flottants), est d'augmenter l'énergie d'adhésion initiale des première et deuxième surfaces, et par là-même d'augmenter la vitesse d'onde de collage des première et deuxième surfaces. En outre, une telle étape b) est simple à mettre en oeuvre à l'échelle industrielle.

Selon une caractéristique de l'invention, l'étape c) est suivie des étapes :

$c_1$) décoller partiellement les premier et deuxième substrats de manière à créer des charges électrostatiques sur des parties des première et deuxième surfaces ;
$c_2$) coller de nouveau le premier substrat au deuxième substrat par une adhésion directe avec lesdites parties des première et deuxième surfaces.

Ainsi, un avantage procuré par l'étape $c_1$) est d'augmenter l'énergie d'adhésion obtenue à l'issue de l'étape c) desdites parties décollées des première et deuxième surfaces, et par là-même d'augmenter la vitesse d'onde de collage desdites parties des première et deuxième surfaces.

Selon une caractéristique de l'invention, l'étape $c_1$) est exécutée de sorte que les parties décollées des première et deuxième surfaces présentent respectivement au moins la moitié de la superficie des première et deuxième surfaces.

Ainsi, un avantage procuré est de pouvoir aisément renouveler l'étape $c_1$) sur des parties complémentaires auxdites parties décollées des première et deuxième surfaces, et ce par simple pivotement des premier et deuxième substrats.

Selon une caractéristique de l'invention, les étapes $c_1$) et $c_2$) sont réitérées sur lesdites parties décollées des première et deuxième surfaces.

Ainsi, un avantage procuré est l'augmentation de l'énergie d'adhésion des première et deuxième surfaces à chaque itération, et par là-même l'augmentation de la vitesse d'onde de collage des première et deuxième surfaces.

Selon une caractéristique de l'invention, les étapes $c_1$) et $c_2$) sont réitérées sur au moins des parties complémentaires auxdites parties décollées des première et deuxième surfaces.

Le terme « partie complémentaire » s'entend ici au sens mathématique. En effet, si l'on note :

- S la superficie totale de la première surface (ou de la deuxième surface),
- $S_1$ la superficie de la partie de la première surface (ou de la deuxième surface) décollée lors de l'étape $C_1$),
- $S_2$ la superficie de la partie complémentaire à la partie décollée de la première surface (ou de la deuxième surface),

alors le terme « partie complémentaire » signifie une zone non-décollée de la première surface (ou de la deuxième surface) lors de l'une itération antérieure de l'étape $c_1$), et vérifiant :

$$S_2 = S\text{-}S_1.$$

Par « au moins une partie complémentaire », on entend que la zone qui va être décollée lors d'une nouvelle itération de l'étape $c_1$) peut avoir une superficie supérieure à $S_2$.

Ainsi, un avantage procuré par la réitération des étapes $c_1$) et $c_2$) est de pouvoir augmenter au fur et à mesure l'énergie d'adhésion et par là-même la vitesse d'onde de collage des première et deuxième surfaces.

Selon une caractéristique de l'invention, le procédé comporte les étapes successives :

a') prévoir les premier et deuxième substrats comprenant respectivement les première et deuxième surfaces possédant l'énergie d'adhésion initiale ;
b') coller le premier substrat au deuxième substrat par une adhésion directe avec les première et deuxième surfaces ;
c') décoller partiellement les premier et deuxième substrats de manière à créer des charges électrostatiques sur des parties des première et deuxième surfaces ;
d') coller de nouveau le premier substrat au deuxième substrat par une adhésion directe avec lesdites parties des première et deuxième surfaces.

Ainsi, un avantage procuré par l'étape c') est d'augmenter l'énergie d'adhésion initiale des première et deuxième surfaces, et par là-même d'augmenter la vitesse d'onde de collage des première et deuxième surfaces.

Selon une caractéristique de l'invention, l'étape c') est exécutée de sorte que les parties décollées des première et deuxième surfaces présentent respectivement au moins la moitié de la superficie des première et deuxième surfaces.

Ainsi, un avantage procuré est de pouvoir aisément renouveler l'étape c') sur des parties complémentaires auxdites parties décollées des première et deuxième surfaces, et ce par simple pivotement des premier et deuxième substrats.

Selon une caractéristique de l'invention, les étapes c') et d') sont réitérées sur lesdites parties décollées des première et deuxième surfaces.

Ainsi, un avantage procuré est l'augmentation de l'énergie d'adhésion des première et deuxième surfaces à chaque itération, et par là-même l'augmentation de la vitesse d'onde de collage des première et deuxième surfaces.

Selon une caractéristique de l'invention, les étapes c') et d') sont réitérées sur au moins des parties complémentaires auxdites parties décollées des première et deuxième surfaces.

Ainsi, un avantage procuré par la réitération des étapes c') et d') est de pouvoir augmenter au fur et à mesure l'énergie d'adhésion et par là-même la vitesse d'onde de collage des première et deuxième surfaces.

Selon une caractéristique de l'invention, l'étape b') comporte une étape consistant à appliquer une tension électrique entre les premier et deuxième substrats collés, de manière à créer des charges électrostatiques aux première et deuxième surfaces, la tension électrique étant de préférence comprise entre 10 V et 250 V.

Ainsi, un avantage procuré par l'application d'une tension électrique après collage est d'augmenter l'énergie d'adhésion initiale des première et deuxième surfaces, et par là-même d'augmenter la vitesse d'onde de collage des première et deuxième surfaces.

Selon une caractéristique de l'invention, l'étape d') comporte une étape consistant à appliquer une tension électrique entre les premier et deuxième substrats collés de nouveau, de manière à créer des charges électrostatiques aux première et deuxième surfaces, la tension électrique étant de préférence comprise entre 10 V et 250 V.

Ainsi, un avantage procuré par l'application d'une tension électrique après collage est d'augmenter l'énergie d'adhésion -obtenue à l'issue de l'étape c')- des première et deuxième surfaces, et par là-même d'augmenter la vitesse d'onde de collage des première et deuxième surfaces.

Selon une caractéristique de l'invention, le procédé comporte les étapes successives :

a") prévoir les premier et deuxième substrats comprenant respectivement les première et deuxième surfaces possédant l'énergie d'adhésion initiale ;
b") coller le premier substrat au deuxième substrat par une adhésion directe avec les première et deuxième surfaces ;
c") appliquer une tension électrique entre les premier et deuxième substrats collés, de manière à créer des charges électrostatiques aux première et deuxième surfaces, la tension électrique étant de préférence comprise entre 10 V et 250 V ;
d") décoller totalement les premier et deuxième substrats ;
e") coller de nouveau le premier substrat au deuxième substrat par une adhésion directe avec les première et deuxième surfaces.

Ainsi, un avantage procuré par l'étape c") est d'augmenter l'énergie d'adhésion initiale des première et deuxième surfaces, et par là-même d'augmenter la vitesse d'onde de collage des première et deuxième surfaces lors de l'étape e").

Selon une caractéristique de l'invention, les première et deuxième surfaces sont réalisées dans un matériau sélectionné parmi Si, Ge, Si-Ge, SiC, $SiO_2$, $GeO_2$, SiN, $Al_2O_3$, InP, AsGa, GaN.

Ainsi, un avantage procuré par de tels matériaux est d'autoriser à la fois un collage par adhésion directe et une création de charges électrostatiques à leur surface.

**Brève description des dessins**

D'autres caractéristiques et avantages apparaîtront dans l'exposé détaillé de différents modes de réalisation de l'invention, l'exposé étant assorti d'exemples et de références aux dessins joints.

Figure 1 est un graphique représentant en abscisses l'énergie d'adhésion (en mJ/m$^2$), et en ordonnées la vitesse d'onde de collage (en mm/s).

Figure 2 est un graphique de principe représentant en abscisses le nombre d'itérations de décollements partiels/recollage des substrats, et en ordonnées la vitesse d'onde de collage (comprise entre les valeurs $V_1$ et $V_2$).

Figure 3 est un graphique de principe représentant en abscisses le nombre d'itérations de décollements partiels/recollage des substrats, et en ordonnées la vitesse d'onde de collage (comprise entre les valeurs $V_1$ et $V_2$). La portion en traits pointillés indique l'application d'une tension électrique sur le collage initial des substrats.

Figure 4 est un graphique de principe représentant en abscisses le nombre d'itérations de décollements partiels/recollage des substrats, et en ordonnées la vitesse d'onde de collage (comprise entre les valeurs $V_1$ et $V_2$). Une tension électrique est appliquée sur chaque collage des substrats.

Figure 5 est une vue schématique en coupe (selon la normale aux première et deuxième surfaces) illustrant un collage direct des deux substrats.

Figure 6 est une vue schématique en coupe (selon la normale aux première et deuxième surfaces) illustrant un décollement partiel des deux substrats.

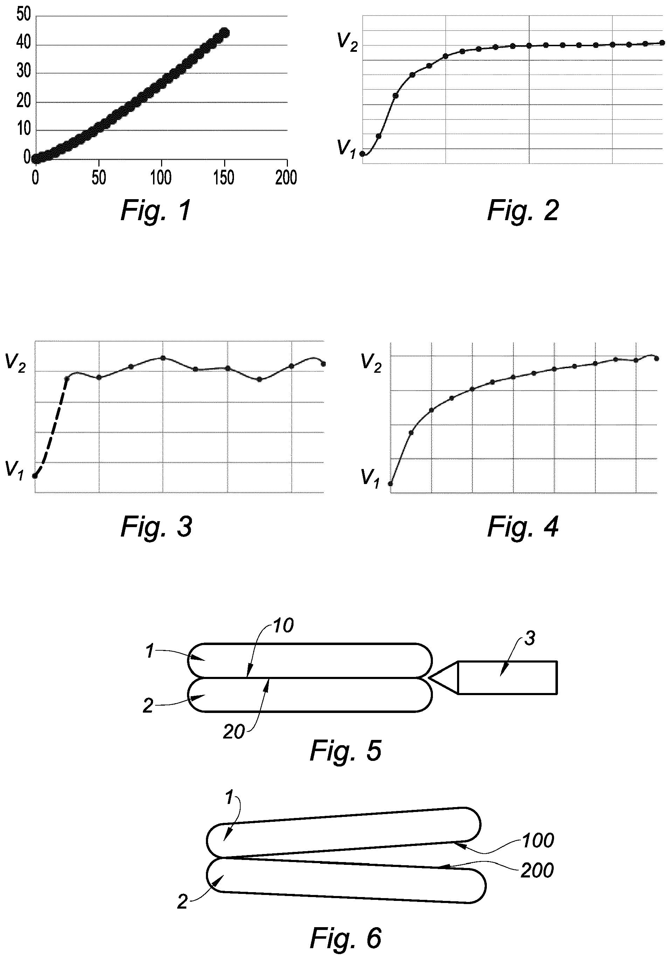

Figures 5 et 6 ne sont pas représentées à l'échelle pour en simplifier leur compréhension.

**Exposé détaillé des modes de réalisation**

Les éléments identiques ou assurant la même fonction porteront les mêmes références pour les différents modes de réalisation, par souci de simplification.

Un objet de l'invention est un procédé de collage par adhésion directe d'un premier substrat 1 à un deuxième substrat 2, les premier et deuxième substrats 1, 2 comprenant respectivement des première et deuxième surfaces 10, 20 possédant une énergie d'adhésion initiale.

Le procédé comporte au moins une étape consistant à créer des charges électrostatiques aux première et deuxième surfaces 10, 20 de manière à obtenir une énergie d'adhésion strictement supérieure à l'énergie d'adhésion initiale. Ainsi, un tel procédé selon l'invention permet d'augmenter la vitesse d'onde de collage des première et deuxième surfaces 10, 20, et ce grâce à ladite au moins une étape de création des charges électrostatiques qui permet d'augmenter l'énergie d'adhésion initiale des première et deuxième surfaces 10, 20. La figure 1 illustre la relation entre l'énergie d'adhésion et la vitesse d'onde de collage.

Ladite au moins une étape est avantageusement exécutée de sorte que les charges électrostatiques créées sont réparties de manière aléatoire aux première et deuxième surfaces 10, 20.

Ladite au moins une étape est avantageusement exécutée de sorte que l'énergie d'adhésion obtenue est comprise entre 50 mJ/m$^2$ et 150 mJ/m$^2$.

Le procédé peut comporter les étapes successives :

- prévoir les premier et deuxième substrats 1, 2 comprenant respectivement les première et deuxième surfaces 10, 20 possédant l'énergie d'adhésion initiale ;
- coller le premier substrat 1 au deuxième substrat 2 par une adhésion directe avec les première et deuxième surfaces 10, 20 ;
- décoller partiellement ou totalement (c'est-à-dire au moins partiellement) les premier et deuxième substrats 1, 2 de manière à créer des charges électrostatiques sur des parties 100, 200 des première et deuxième surfaces 10, 20 ;
- coller de nouveau le premier substrat 1 au deuxième substrat 2 par une adhésion directe avec lesdites parties 100, 200 des première et deuxième surfaces 10, 20.

La succession de collage et décollage augmente l'énergie d'adhésion des première et deuxième surfaces 10, 20 à chaque itération de manière à augmenter la vitesse d'onde de collage des première et deuxième surfaces 10, 20.

**Premier et deuxième substrats**

Les première et deuxième surfaces 10, 20 sont avantageusement réalisées dans un matériau sélectionné parmi Si, Ge, Si-Ge, SiC, SiO$_2$, GeO$_2$, SiN, Al$_2$O$_3$, InP, AsGa, GaN. De tels matériaux autorisent à la fois un collage par adhésion directe et une création de charges électrostatiques à leur surface.

Lorsque les premier et deuxième substrats 1, 2 sont chacun réalisés dans un matériau n'autorisant pas à la fois un collage par adhésion directe et une création de charges électrostatiques à leur surface (e.g. des substrats 1, 2 métalliques), alors les premier et deuxième substrats 1, 2 comportent avantageusement chacun une couche superficielle réalisée dans un matériau autorisant à la fois un collage par adhésion directe et une création de charges électrostatiques.

**Premier mode de mise en oeuvre**

Selon le premier mode de mise en oeuvre, le procédé comporte les étapes successives :

a) prévoir les premier et deuxième substrats 1, 2 comprenant respectivement les première et deuxième surfaces 10, 20 possédant l'énergie d'adhésion initiale ;

b) appliquer des potentiels électriques aux première et deuxième surfaces 10, 20 de manière à créer des charges électrostatiques ;

c) coller le premier substrat 1 au deuxième substrat 2 par une adhésion directe avec les première et deuxième surfaces 10, 20.

Les potentiels électriques appliqués lors de l'étape b) sont flottants. En effet, afin de ne pas dégrader les première et deuxième surfaces 10, 20 à coller, seules les faces arrière sont mises en contact avec une électrode à laquelle le potentiel électrique désiré est appliqué.

L'étape c) est préférentiellement exécutée à température ambiante, c'est-à-dire entre 20°C et 30°C.

L'étape c) peut être suivie des étapes :

$c_1$) décoller partiellement les premier et deuxième substrats 1, 2 de manière à créer des charges électrostatiques sur des parties 100, 200 des première et deuxième surfaces 10, 20 ;

$c_2$) coller de nouveau le premier substrat 1 au deuxième substrat 2 par une adhésion directe avec lesdites parties 100, 200 des première et deuxième surfaces 10, 20.

L'étape $c_1$) est avantageusement exécutée de sorte que les parties 100, 200 décollées des première et deuxième surfaces 10, 20 présentent respectivement au moins la moitié, de préférence au moins 2/3, de la superficie des première et deuxième surfaces 10, 20. Une telle étape $c_1$) permet de créer des charges électrostatiques réparties de manière aléatoire aux première et deuxième surfaces 10, 20. Comme illustré à la figure 5, l'étape $c_1$) peut être exécutée à l'aide d'une lame 3, de préférence réalisée dans un matériau plastique, insérée au niveau des chanfreins des premier et deuxième substrats 1, 2.

Lors de l'étape $c_2$), les charges électrostatiques réparties aux première et deuxième surfaces 10, 20 se retrouvent en regard, ce qui permet d'augmenter la vitesse d'onde de collage.

Les étapes $c_1$) et $c_2$) sont avantageusement réitérées sur lesdites mêmes parties 100, 200 décollées des première et deuxième surfaces 10, 20. Le nombre de réitérations peut être compris entre 1 et 20.

Les étapes $c_1$) et $c_2$) sont avantageusement réitérées sur au moins des parties complémentaires auxdites parties 100, 200 décollées des première et deuxième surfaces 10, 20. Les étapes $c_1$) et $c_2$) sont avantageusement réitérées sur lesdites mêmes parties complémentaires auxdites parties 100, 200 décollées des première et deuxième surfaces 10, 20. L'évolution de la vitesse d'onde de collage est illustrée à la figure 3. Les étapes $c_1$) et $c_2$) sont préférentiellement exécutées à température ambiante, c'est-à-dire entre 20°C et 30°C.

Deuxième mode de mise en oeuvre

Selon le deuxième mode de mise en oeuvre, le procédé comporte les étapes successives :

a') prévoir les premier et deuxième substrats 1, 2 comprenant respectivement les première et deuxième surfaces 10, 20 possédant l'énergie d'adhésion initiale ;
b') coller le premier substrat 1 au deuxième substrat 2 par une adhésion directe avec les première et deuxième surfaces 10, 20 ;
c') décoller partiellement les premier et deuxième substrats 1, 2 de manière à créer des charges électrostatiques sur des parties 100, 200 des première et deuxième surfaces 10, 20 ;
d') coller de nouveau le premier substrat 1 au deuxième substrat 2 par une adhésion directe avec lesdites parties 100, 200 des première et deuxième surfaces 10, 20.

L'étape b') est préférentiellement exécutée à température ambiante, c'est-à-dire entre 20°C et 30°C.

L'étape c') est avantageusement exécutée de sorte que les parties 100, 200 décollées des première et deuxième surfaces 10, 20 présentent respectivement au moins la moitié, de préférence au moins 2/3, de la superficie des première et deuxième surfaces 10, 20. Une telle étape c') permet de créer des charges électrostatiques réparties de manière aléatoire aux première et deuxième surfaces 10, 20. Comme illustré à la figure 5, l'étape c') peut être exécutée à l'aide d'une lame 3, de préférence réalisée dans un matériau plastique, insérée au niveau des chanfreins des premier et deuxième substrats 1, 2.

Lors de l'étape d'), les charges électrostatiques réparties aux première et deuxième surfaces 10, 20 se retrouvent en regard, ce qui permet d'augmenter la vitesse d'onde de collage.

Les étapes c') et d') sont avantageusement réitérées sur lesdites mêmes parties 100, 200 décollées des première et deuxième surfaces 10, 20. Le nombre de réitérations peut être compris entre 1 et 20.

Les étapes c') et d') sont avantageusement réitérées sur au moins des parties complémentaires auxdites parties 100, 200 décollées des première et deuxième surfaces 10, 20. Les étapes c') et d') sont avantageusement réitérées sur lesdites mêmes parties complémentaires auxdites parties 100, 200 décollées des première et deuxième surfaces 10, 20. L'évolution de la vitesse d'onde de collage est illustrée à la figure 2. Les étapes c') et d') sont préférentiellement exécutées à température ambiante, c'est-à-dire entre 20°C et 30°C.

L'étape b') comporte avantageusement une étape consistant à appliquer une tension électrique entre les premier et deuxième substrats 1, 2 collés, de manière à créer des charges électrostatiques aux première et deuxième surfaces 10, 20, la tension électrique étant de préférence comprise entre 10 V et 250 V. Une telle étape b') permet de créer des charges électrostatiques, réparties de manière aléatoire aux première et deuxième surfaces 10, 20, les charges électrostatiques étant en regard les unes des autres. L'étape d') comporte avantageusement une étape consistant à appliquer une tension électrique entre les premier et deuxième substrats 1, 2 collés de nouveau, de manière à créer des charges électrostatiques aux première et deuxième surfaces 10, 20, la tension électrique étant de préférence comprise entre 10 V et 250 V. Une telle étape d') permet de créer des charges électrostatiques, réparties de manière aléatoire aux première et deuxième surfaces 10, 20, les charges électrostatiques étant en regard les unes des autres. L'évolution de la vitesse d'onde de collage est illustrée à la figure 4, lorsque des tensions électriques sont appliquées sur les collages des étapes b') et d').

Troisième mode de mise en oeuvre

Selon le troisième mode de mise en oeuvre, le procédé comporte les étapes successives :

a") prévoir les premier et deuxième substrats 1, 2 comprenant respectivement les première et deuxième surfaces 10, 20 possédant l'énergie d'adhésion initiale ;
b") coller le premier substrat 1 au deuxième substrat 2 par une adhésion directe avec les première et deuxième surfaces 10, 20 ;
c") appliquer une tension électrique entre les premier et deuxième substrats 1, 2 collés, de manière à créer des charges électrostatiques aux première et deuxième surfaces 10, 20, la tension électrique étant de préférence comprise entre 10 V et 250 V ;

d") décoller totalement les premier et deuxième substrats 1, 2 ;

e") coller de nouveau le premier substrat 1 au deuxième substrat 2 par une adhésion directe avec les première et deuxième surfaces 10, 20.

Les étapes b"), d") et e") sont préférentiellement exécutées à température ambiante, c'est-à-dire entre 20°C et 30°C.

Comme illustré à la figure 5, l'étape d") peut être exécutée à l'aide d'une lame 3, de préférence réalisée dans un matériau plastique, insérée au niveau des chanfreins des premier et deuxième substrats 1, 2.

Exemple de mise en oeuvre n°1

Les premier et deuxième substrats 1, 2 sont deux tranches de silicium <001> de 200 mm de diamètre et de 725 $\mu$m d'épaisseur. Les premier et deuxième substrats 1, 2 sont nettoyés et hydrolysés dans des bains d'eau déionisée enrichie en ozone et dans une solution d'APM *(« Ammonia-Peroxyde Mixture »* en langue anglaise) à 70°C. Les premier et deuxième substrats 1, 2 sont collés par collage direct à température ambiante, et à pression ambiante. On note $V_1$ la vitesse de l'onde moyenne obtenue lors de la propagation spontanée du collage direct. L'onde de collage est visualisée au moyen d'une caméra infra-rouge. Une source de lumière infra-rouge (de longueur d'onde autour de 1 $\mu$m) est placée sous le collage. Ensuite on insère une lame 3 en plastique entre les premier et deuxième substrats 1, 2 en prenant soin de ne pas toucher les surfaces mais seulement les chanfreins des substrats 1, 2 afin de ne pas apporter de contamination particulaire ou organique à l'interface de collage. On provoque un décollement sur les deux tiers des première et deuxième surfaces 10, 20. Ensuite, on retire la lame 3 en plastique et le collage se propage à nouveau. On réitère cette opération environ une dizaine de fois. Comme on peut le voir sur la figure 2, la vitesse d'onde de collage augmente au fur et à mesure des décollements partiels. On obtient une vitesse d'onde de collage $V_2$ qui est environ deux fois plus grande que $V_1$. Dans cet exemple, $V_1$ vaut environ 16 mm/s, et $V_2$ vaut environ 32 mm/s. On peut ensuite faire pivoter de 180° les premier et deuxième substrats 1, 2 collés, et réitérer les décollements sur des parties complémentaires afin d'obtenir une forte énergie d'adhésion sur toute la superficie des première et deuxième surfaces 10, 20.

Exemple de mise en oeuvre n°2

Les premier et deuxième substrats 1, 2 sont deux tranches de silicium <001> de 200 mm de diamètre et de 725 $\mu$m d'épaisseur, recouvertes d'une couche d'oxyde thermique de 145nm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C. Un plasma de diazote N$_2$ est réalisé sur les premier et deuxième substrats 1, 2 pendant 15 s, sous 0,3 mbar d'azote en mode RIE (« *Reactive-Ion Etching* » en langue anglaise), avec une fréquence de 13,56 MHz. Les premier et deuxième substrats 1, 2 sont collés par collage direct à température ambiante, et à pression ambiante. On note $V_1$ la vitesse de l'onde moyenne obtenue lors de la propagation spontanée du collage direct. Ensuite, on applique une tension de 75 V sur le collage. On provoque un décollage partiel et on obtient tout de suite une vitesse d'onde de collage $V_2$ qui est environ deux fois plus importante que $V_1$. Les décollages partiels suivants ont peu d'impact dans le cas décrit sur la figure 2. Dans cet exemple, $V_1$ vaut environ 30mm/s, et $V_2$ vaut environ 60 mm/s.

Exemple de mise en oeuvre n°3

Les premier et deuxième substrats 1, 2 sont deux tranches de silicium <001> de 200 mm de diamètre et de 725 $\mu$m d'épaisseur, recouvertes d'une couche d'oxyde thermique de 145 nm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C. Les premier et deuxième substrats 1, 2 sont collés par collage direct à température ambiante et à pression ambiante. On note $V_1$ la vitesse de l'onde moyenne obtenue lors de la propagation spontanée du collage direct. Ensuite on décolle complétement les premier et deuxième substrats 1, 2. On applique une tension de 250 V sur un des deux substrats 1, 2. On procède de nouveau à un collage direct des premier et deuxième substrats 1, 2, et on mesure une vitesse d'onde de collage $V_2$ qui est environ 50% plus élevée que $V_1$. Dans cet exemple, il n'est pas nécessaire de réaliser le premier collage direct qui n'est ici envisagé que pour montrer l'augmentation de vitesse de propagation d'onde de $V_1$ à $V_2$. Dans cet exemple, $V_1$ vaut environ 20 mm/s, et $V_2$ vaut environ 30 mm/s.

Exemple de mise en oeuvre n°4

Les premier et deuxième substrats 1, 2 sont deux tranches de silicium <001> de 200 mm de diamètre et de 725 $\mu$m d'épaisseur, recouvertes d'une couche d'oxyde thermique de 145 nm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C. Les premier et deuxième substrats 1, 2 sont collés par collage direct à température ambiante, et à pression ambiante. On note $V_1$ la vitesse de l'onde moyenne obtenue lors de la propagation spontanée du collage direct. Ensuite, on décolle complétement les premier et deuxième substrats 1, 2.

On applique une tension de 250 V sur les deux substrats 1, 2. On procède de nouveau à un collage direct des premier et deuxième substrats 1, 2, et on mesure une vitesse d'onde de collage $V_2$ qui est environ deux fois plus élevée que $V_1$. Dans cet exemple, il n'est pas nécessaire de réaliser le premier collage direct qui n'est ici envisagé que pour montrer l'augmentation de vitesse de propagation d'onde de $V_1$ à $V_2$. Dans cet exemple, $V_1$ vaut environ 20 mm/s et $V_2$ vaut environ 40 mm/s.

Exemple de mise en oeuvre n°5

Les premier et deuxième substrats 1, 2 sont deux tranches de silicium <001> de 200 mm de diamètre et de 725 $\mu$m d'épaisseur, recouvertes d'une couche d'oxyde thermique de 145 nm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C. Les premier et deuxième substrats 1, 2 sont collés par collage direct à température ambiante, et à pression ambiante. On note $V_1$ la vitesse de l'onde moyenne obtenue lors de la propagation spontanée du collage direct. On applique une tension de 250 V sur l'empilement des deux substrats 1, 2 collés. On décolle complètement les premier et deuxième substrats 1, 2. On procède de nouveau à un collage direct des premier et deuxième substrats 1, 2, et on mesure une vitesse $V_2$ qui est environ deux fois plus élevée que $V_1$. Dans cet exemple, $V_1$ vaut environ 20 mm/s, et $V_2$ vaut environ 40 mm/s.

Exemple de mise en oeuvre n°6

Les premier et deuxième substrats 1, 2 sont deux tranches de silicium <001> de 200 mm de diamètre et de 725 $\mu$m d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C. Un plasma de diazote $N_2$ est réalisé sur les premier et deuxième substrats 1, 2 pendant 15 s, sous 0,3 mbar d'azote en mode RIE *(« Keactive-Ion Etching* » en langue anglaise) avec une fréquence de 13,56 MHz. Les premier et deuxième substrats 1, 2 sont collés par collage direct à température ambiante, et à pression ambiante. On note $V_1$ la vitesse de l'onde moyenne obtenue lors de la propagation spontanée du collage direct. On applique une tension de 250 V sur l'empilement des deux substrats 1, 2 collés. On décolle partiellement les premier et deuxième substrats 1, 2. On procède de nouveau à un collage direct des premier et deuxième substrats 1, 2. Les étapes de décollements partiels/collages directs sont réitérées de multiples fois, et avec une application de la tension sur chaque collage direct. Comme le montre la figure 4, la vitesse d'onde $V_2$ augmente au fur et à mesure jusqu'à atteindre deux fois $V_1$. Dans cet exemple, $V_1$ vaut environ 30 mm/s, et $V_2$

vaut environ 60 mm/s.

L'invention ne se limite pas aux modes de réalisation exposés. L'homme du métier est mis à même de considérer leurs combinaisons techniquement opérantes, et de leur substituer des équivalents.

**Revendications**

1. Procédé de collage par adhésion directe d'un premier substrat (1) à un deuxième substrat (2), les premier et deuxième substrats (1, 2) comprenant respectivement des première et deuxième surfaces (10, 20) possédant une énergie d'adhésion initiale ;
le procédé comportant au moins une étape consistant à créer des charges électrostatiques aux première et deuxième surfaces (10, 20) de manière à obtenir une énergie d'adhésion strictement supérieure à l'énergie d'adhésion initiale ;
le procédé comportant les étapes successives :

   - prévoir les premier et deuxième substrats (1, 2) comprenant respectivement les première et deuxième surfaces (10, 20) possédant l'énergie d'adhésion initiale ;
   - coller le premier substrat (1) au deuxième substrat (2) par une adhésion directe avec les première et deuxième surfaces (10, 20) ;
   - décoller au moins partiellement les premier et deuxième substrats (1, 2) de manière à créer des charges électrostatiques sur des parties (100, 200) des première et deuxième surfaces (10, 20) ;
   - coller de nouveau le premier substrat (1) au deuxième substrat (2) par une adhésion directe avec lesdites parties (100, 200) des première et deuxième surfaces (10, 20).

2. Procédé selon la revendication 1, dans lequel ladite au moins une étape est exécutée de sorte que les charges électrostatiques créées sont réparties de manière aléatoire aux première et deuxième surfaces (10, 20).

3. Procédé selon la revendication 1 ou 2, dans lequel ladite au moins une étape est exécutée de sorte que l'énergie d'adhésion obtenue est comprise entre 50 mJ/m$^2$ et 150 mJ/m$^2$.

4. Procédé selon l'une des revendications 1 à 3, comportant les étapes successives :

   a) prévoir les premier et deuxième substrats (1, 2) comprenant respectivement les première et deuxième surfaces (10, 20) possédant l'énergie d'adhésion initiale ;
   b) appliquer des potentiels électriques aux première et deuxième surfaces (10, 20) de manière à créer des charges électrostatiques ;

c) coller le premier substrat (1) au deuxième substrat (2) par une adhésion directe avec les première et deuxième surfaces (10, 20) ; l'étape c) étant suivie des étapes :

$c_1$) décoller partiellement les premier et deuxième substrats (1, 2) de manière à créer des charges électrostatiques sur des parties (100, 200) des première et deuxième surfaces (10, 20) ;

$c_2$) coller de nouveau le premier substrat (1) au deuxième substrat (2) par une adhésion directe avec lesdites parties (100, 200) des première et deuxième surfaces (10, 20).

5. Procédé selon la revendication 4, dans lequel l'étape $c_1$) est exécutée de sorte que les parties (100, 200) décollées des première et deuxième surfaces (10, 20) présentent respectivement au moins la moitié de la superficie des première et deuxième surfaces (10, 20).

6. Procédé selon la revendication 4 ou 5, dans lequel les étapes $c_1$) et $c_2$) sont réitérées sur lesdites parties (100, 200) décollées des première et deuxième surfaces (10, 20).

7. Procédé selon l'une des revendications 4 à 6, dans lequel les étapes $c_1$) et $c_2$) sont réitérées sur au moins des parties complémentaires auxdites parties (100, 200) décollées des première et deuxième surfaces (10, 20).

8. Procédé selon l'une des revendications 1 à 3, comportant les étapes successives :

a') prévoir les premier et deuxième substrats (1, 2) comprenant respectivement les première et deuxième surfaces (10, 20) possédant l'énergie d'adhésion initiale ;

b') coller le premier substrat (1) au deuxième substrat (2) par une adhésion directe avec les première et deuxième surfaces (10, 20) ;

c') décoller partiellement les premier et deuxième substrats (1, 2) de manière à créer des charges électrostatiques sur des parties (100, 200) des première et deuxième surfaces (10, 20) ;

d') coller de nouveau le premier substrat (1) au deuxième substrat (2) par une adhésion directe avec lesdites parties (100, 200) des première et deuxième surfaces (10, 20).

9. Procédé selon la revendication 8, dans lequel l'étape c') est exécutée de sorte que les parties (100, 200) décollées des première et deuxième surfaces (10, 20) présentent respectivement au moins la moitié de la superficie des première et deuxième surfaces (10, 20).

20).

10. Procédé selon la revendication 8 ou 9, dans lequel les étapes c') et d') sont réitérées sur lesdites parties (100, 200) décollées des première et deuxième surfaces (10, 20).

11. Procédé selon l'une des revendications 8 à 10, dans lequel les étapes c') et d') sont réitérées sur au moins des parties complémentaires auxdites parties (100, 200) décollées des première et deuxième surfaces (10, 20).

12. Procédé selon l'une des revendications 8 à 11, dans lequel l'étape b') comporte une étape consistant à appliquer une tension électrique entre les premier et deuxième substrats (1, 2) collés, de manière à créer des charges électrostatiques aux première et deuxième surfaces (10, 20), la tension électrique étant de préférence comprise entre 10 V et 250 V.

13. Procédé selon l'une des revendications 8 à 12, dans lequel l'étape d') comporte une étape consistant à appliquer une tension électrique entre les premier et deuxième substrats (1, 2) collés de nouveau, de manière à créer des charges électrostatiques aux première et deuxième surfaces (10, 20), la tension électrique étant de préférence comprise entre 10 V et 250 V.

14. Procédé selon l'une des revendications 1 à 3, comportant les étapes successives :

a") prévoir les premier et deuxième substrats (1, 2) comprenant respectivement les première et deuxième surfaces (10, 20) possédant l'énergie d'adhésion initiale ;

b") coller le premier substrat (1) au deuxième substrat (2) par une adhésion directe avec les première et deuxième surfaces (10, 20) ;

c") appliquer une tension électrique entre les premier et deuxième substrats (1, 2) collés, de manière à créer des charges électrostatiques aux première et deuxième surfaces (10, 20), la tension électrique étant de préférence comprise entre 10 V et 250 V ;

d") décoller totalement les premier et deuxième substrats (1, 2) ;

e") coller de nouveau le premier substrat (1) au deuxième substrat (2) par une adhésion directe avec les première et deuxième surfaces (10, 20).

15. Procédé selon l'une des revendications 1 à 14, dans lequel les première et deuxième surfaces (10, 20) sont réalisées dans un matériau sélectionné parmi Si, Ge, Si-Ge, SiC, $SiO_2$, $GeO_2$, SiN, $Al_2O_3$, InP, As-Ga, GaN.

Fig. 1

Fig. 2

Fig. 3

Fig. 4

Fig. 5

Fig. 6

**EP 3 496 133 A1**

Europäisches Patentamt
European Patent Office
Office européen des brevets

# RAPPORT DE RECHERCHE EUROPEENNE

Numéro de la demande

EP 18 20 9588

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2015/221540 A1 (QIN SHU [US] ET AL) 6 août 2015 (2015-08-06) * alinéa [0018] - alinéa [0026]; figures 2A-3 * ----- | 1-15 | INV. H01L21/20 |
| A | US 2012/120545 A1 (FUJISAWA HIROSHI [JP] ET AL) 17 mai 2012 (2012-05-17) * alinéa [0031] - alinéa [0036]; figures 1A-1B; exemple 1 * ----- | 1 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| La Haye | 28 janvier 2019 | Hedouin, Mathias |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

11

**ANNEXE AU RAPPORT DE RECHERCHE EUROPEENNE
RELATIF A LA DEMANDE DE BREVET EUROPEEN NO.**

EP 18 20 9588

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-01-2019

| Document brevet cité au rapport de recherche | Date de publication | Membre(s) de la famille de brevet(s) | Date de publication |
|---|---|---|---|
| US 2015221540 A1 | 06-08-2015 | CN 106062938 A | 26-10-2016 |
| | | EP 3103134 A1 | 14-12-2016 |
| | | JP 2017506429 A | 02-03-2017 |
| | | KR 20160115983 A | 06-10-2016 |
| | | TW 201543588 A | 16-11-2015 |
| | | US 2015221540 A1 | 06-08-2015 |
| | | WO 2015119798 A1 | 13-08-2015 |
| US 2012120545 A1 | 17-05-2012 | CN 102473668 A | 23-05-2012 |
| | | EP 2450948 A1 | 09-05-2012 |
| | | HK 1168200 A1 | 31-07-2015 |
| | | JP 5500172 B2 | 21-05-2014 |
| | | JP WO2011001978 A1 | 13-12-2012 |
| | | KR 20120100883 A | 12-09-2012 |
| | | KR 20170010105 A | 25-01-2017 |
| | | SG 177448 A1 | 28-02-2012 |
| | | TW 201130081 A | 01-09-2011 |
| | | US 2012120545 A1 | 17-05-2012 |
| | | WO 2011001978 A1 | 06-01-2011 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **F. RIEUTORD et al.** Dynamics of a Bonding Front. *Phys. Rev. Lett.,* 2005, vol. 94, 236101